# EUROPEAN PATENT APPLICATION

(11) **EP 1 104 182 A1**
(43) Date of publication of application: **30.05.2001**
(21) Application number: 00308955.4
(22) Date of filing: 11.10.2000
(51) Int. Cl.: H04N 5/225

(54) **Improved image sensor devices for Incorporation into endoscopes**

(30) Priority: 27.11.1999 GB 9928025
(71) Applicant: STMicroelectronics Limited, Marlow, Buckinghamshire SL7 1YL (GB)
(72) Inventor: Raynor, Jeffrey, Edinburgh EH12 5BD (GB)
(74) Representative: Cooper, John

(57) **Abstract**

An image sensor device has a solid state imaging device mounted on a printed circuit board. The solid state imaging device has a number of electrical terminals on a reverse surface thereof for electrical connection to a first portion of the printed circuit board. The printed circuit board is at least partially flexible such that a second portion is bent relative to said first portion. An endoscope apparatus is disclosed, in which the image sensor device is positioned within the distal end of a tubular casing.

## Description

The present invention relates to image sensor devices. More particularly, the invention relates to improvements whereby the overall dimensions of an image sensor device are reduced. The invention finds particular application in endoscope apparatus.

Endoscope apparatus (e.g. for use in "minimally invasive" surgical techniques) is known in which a solid state imaging device and associated components and cabling are provided in the tip of the endoscope (i.e. "distal" type endoscopes, as distinct from "proximal" types, in which there is an optical path from the tip either directly to the eye of the user or to a camera). The tip of an endoscope typically comprises a cylindrical casing. It is obviously desirable for the diameter of the endoscope tip to be made as small as possible. It is also desirable for the area of the sensor array of the imaging device to be as large as possible.

Known endoscope systems with distal imaging are relatively expensive devices which are designed to be re-usable. This requires the devices to be capable of surviving repeated high temperature sterilization cycles, which in turn requires high-specification product design and further increases the cost of the equipment. However, the re-usability of the devices justifies a higher capital cost enabling the use of relatively elaborate and expensive designs and assembly techniques.

An alternative to expensive, re-usable endoscope systems is lower cost, disposable systems. This eliminates any problems of cross-contamination between patients and enables use in situations where the cost of re-usable systems is prohibitive. However, the unit cost of a disposable device must be as low as possible, requiring simplified designs and assembly techniques.

Typical endoscope systems have an outside diameter in the range 5 mm to 10 mm, which must accommodate the wall thickness of the endoscope outer casing, the image sensor package and the mounting of the image sensor package. Advances in semiconductor technology have allowed reductions in the size of image sensor chips. However, conventional packaging techniques result in a packaged sensor device being substantially larger than the sensor chip itself. Most semiconductor chips are packaged in plastic or ceramic materials which are opaque and therefore not suitable for imaging devices. Most image sensors are packaged in ceramic with a glass lid. Such packaging techniques typically add 2 mm to 3 mm per side to the size of the sensor chip. This size overhead is very significant for a 10 mm diameter endoscope and prohibitive for a 5 mm diameter endoscope.

Many re-usable endoscopes employ packaging techniques which require a large amount of hand assembly, which is time-consuming and hence expensive, and unsuited for the manufacture of low cost, disposable endoscope devices.

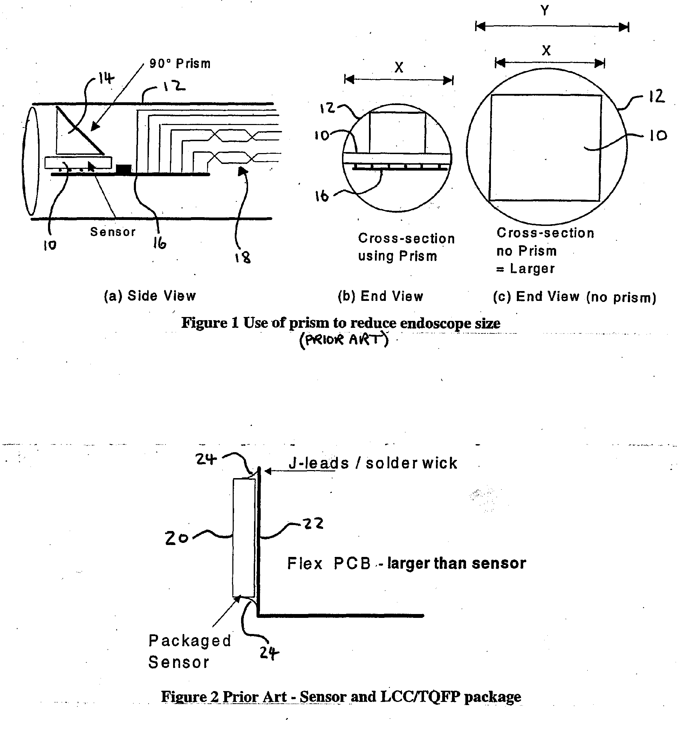

Figure 1 illustrates known methods of mounting imaging devices in the tip of an endoscope. As seen in Figure 1(c), if a square imaging device 10 having sides of length X is mounted transversely with the sensor array normal to the longitudinal axis of the endoscope tube 12, the tube 12 must have an inner diameter Y which is substantially greater than X. Figures 1(a) and 1(b) illustrate the same imaging device 10 mounted "in-line", parallel to the longitudinal axis of the endoscope tube 12. This allows the inner diameter of the tube 12 to be equal to or slightly greater than the length X of the imaging device. However, it is necessary for a prism 14 or the like to be employed to divert the light entering the tip of the endoscope so as to impinge upon the sensor array of the imaging device 10. As is also seen in Figure 1(a), the imaging device 10 is mounted on a printed circuit board (PCB) 16 and the PCB 16 is connected to a number of cables 18.

The arrangement shown in Figures 1(a) and 1(b) allows the diameter of the endoscope casing to be reduced for a given size of imaging device. However, the cost and complexity of the imaging system is increased and is unsuitable for disposable systems. The transverse mounting of Figure 1(c) is simpler and cheaper. However, conventional semiconductor packaging and mounting techniques result in the useful sensing area of the sensor package being substantially smaller than the overall area of the device 10, so that the performance of the device is reduced for a given diameter Y of the endoscope casing 12.

Besides the packaging of the sensor chip, the mounting of the sensor package on a PCB further increases the overall size of the device. Figure 2 illustrates a conventional sensor package 20 mounted on a flexible PCB 22. A conventional sensor package 20 has electrical connecting leads 24 around its periphery, which are soldered to the PCB 22, further increasing the space required for the system and further reducing the available useful sensing area in the arrangement illustrated in Figure 1(c).

US-A-5,962,842 exemplifies prior art endoscope imaging systems.

In accordance with a first aspect of the present invention, there is provided an image sensor device comprising a solid state imaging device including an image sensor array and mounted on a printed circuit board, wherein said solid state imaging device includes a plurality of electrical terminals on a reverse surface thereof whereby the solid state imaging device is electrically connected to a first portion of said printed circuit board, and wherein said printed circuit board is at least partially flexible so as to enable at least a second portion thereof to be bent relative to said first portion.

Preferably, said solid state imaging device comprises a packaged sensor chip, said sensor chip having a plurality of electrical contact pads disposed on the periphery thereof, and said contact pads being connected to said terminals by means of electrically conductive tracks formed on an exterior surface of the solid state imaging device and extending rearwardly from said contact pads around said exterior surface of the solid state imaging device.

Preferably, edges of said sensor chip are exposed at the sides of said solid state imaging device.

Preferably, said sensor chip includes a transparent front cover member.

Preferably, said sensor chip is sandwiched between said transparent front cover member and a rear cover member, and edges of said sensor chip are exposed at the sides of said solid state imaging device between said front and rear cover members.

Most preferably, said front and rear cover members are both formed from glass.

Preferably, said first portion of said printed circuit board has an area no larger than the area of the solid state imaging device plus 1 mm per side, and said at least one second portion of said printed circuit board comprises at least one tail portion extending from at least one edge of said first portion, said tail portion being capable of being bent rearwardly with respect to said solid state imaging device so as to be disposed within the volume of a notional parallelepiped projected rearwardly from said solid state imaging device.

Most preferably, said first portion of said printed circuit board has an area equal to or less than the area of the solid state imaging device.

Preferably, said tail portion is adapted to have at least one electrical cable connected thereto.

Preferably, said printed circuit board is a flexible printed circuit board. Optionally, said flexible printed circuit board includes mechanical stiffening means associated with said first portion thereof.

Alternatively, said printed circuit board is a flex-rigid printed circuit board, including flexible elements at least in portions thereof connecting said first and second portions.

In accordance with a second aspect of the invention, there is provided endoscope apparatus comprising a generally tubular casing having an image sensor device in accordance with the first aspect of the invention located in said casing adjacent a distal end of the apparatus with said sensor array disposed substantially at right angles to a longitudinal axis of said casing.

US-A-4,745,470 discloses distal endoscope designs, including embodiments in which the sensor packages are mounted both in-line, with suitable prism systems, and transversely. The sensor packages are of a type in which the package terminals are located on the reverse surface of the package and, to this extent, are somewhat similar to the sensor packages employed by the present invention. However, the sensor packages of US-A-4,745,470 employ substantially conventional packaging techniques in which the sensor chip is die bonded to a ceramic base and wire bonding is employed to connect contact pads on the sensor chip to conductive tracks on the ceramic base, leading to terminals on the reverse of the package. This arrangement is still wasteful of space and substantially increases the size of the sensor package. US-A-4,745,470 does not contemplate the use of a flexible PCB for mounting the sensor package and the systems disclosed therein are generally unsuitable for disposable use.

Embodiments of the invention will now be described, by way of example only, with reference to the accompanying drawings, in which:
Figure 1(a) is a schematic, sectional side view of a known type of endoscope imaging system;
Figure 1(b) is a schematic, sectional end view of the imaging system of Figure 1(a);
Figure 1(c) is a schematic sectional end view of another known type of endoscope imaging system for comparison with Figs. 1(a) and 1(b);
Figure 2 is a schematic side view of a known image sensor device wherein a solid state imaging device is mounted on a flexible printed circuit board;
Figure 3 is a schematic side view of one example of an image sensor device embodying the present invention;
Figure 4 is a schematic sectional side view of a solid state imaging device employed in the image sensor device of Figure 3;
Figure 5(a) and 5(b) are, respectively, schematic front and rear views of the device of Figure 4;
Figures 6(a) to 6(h) are schematic diagrams illustrating the process of manufacturing devices such as that of Figure 5; and
Figure 7 is a schematic sectional side view of endoscope apparatus incorporating an image sensor device in accordance with the present invention.

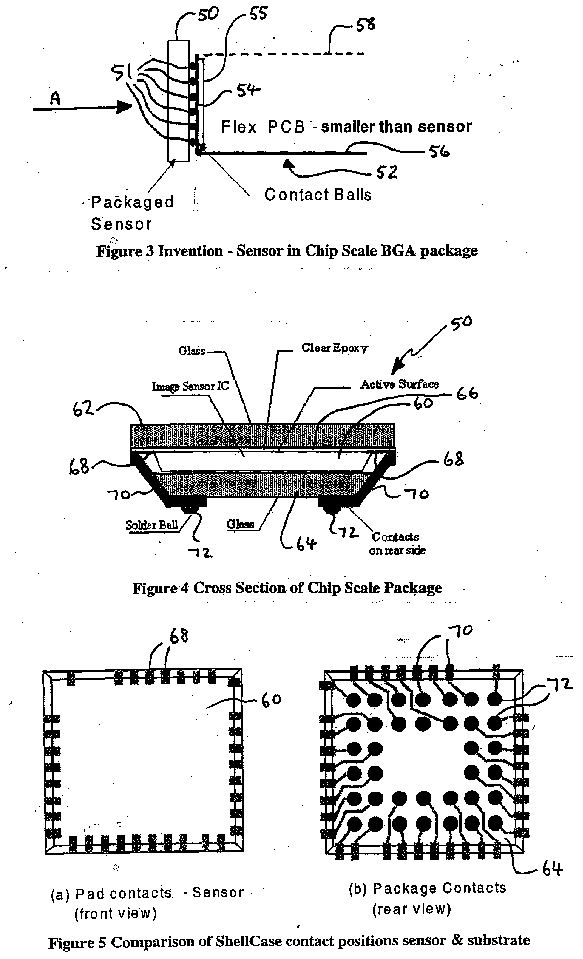

Referring now to Figs. 3 to 7 of the drawings, Fig. 3 illustrates an image sensor device in accordance with the invention, comprising a solid state imaging device 50 mounted on a flexible printed circuit board (PCB) 52. In accordance with the invention, the device 50 comprises an image sensor chip packaged such that the terminals 51 by means of which the device 50 is electrically connected to the PCB 52 are located on a reverse surface of the device 50, as shall be discussed in greater detail below. The portion 54 of the PCB 52 to which the device 50 is connected may thus have a surface area equal to or smaller than the device 50. In accordance with the invention, the portion 54 of the PCB may be made slightly larger than the device 50 (e.g. with a border up to about 1 mm between the edge of the device 50 and the edge of the portion 54) and still provide an advantageous space-saving in comparison with the prior art. The flexibility of the PCB 52 allows a tail portion 56 extending from one side of the portion 54 thereof to be bent rearwardly from the device 50, so that the overall area of the image sensor device when viewed in the direction A is no greater than that of the device 50. Additional components may be mounted on the tail portion 56 of the PCB 52 if necessary, and all necessary cables can be connected to the tail portion 56. If required, the PCB 52 may include one or more additional tail portions extending from the remaining sides of the portion 54 thereof, as indicated at 58.

Optionally, the mechanical stability of the bent PCB 52 may be improved by the provision of a stiffening element 55 associated with the PCB portion 54. The stiffening element may comprise a planar member of material such as thick polyimide film or metal incorporated into the PCB portion 54 or secured to the surface thereof opposite the surface to which the device 50 is attached.

In a further alternative, the PCB 54 may be of "flex-rigid" type; i.e. a hybrid structure comprising rigid PCB portions and flexible elements where bends or creases are required. In the present case, at least the portion 54 of the PCB would be rigid and the bend portions would be flexible. The tail portions 56, 58 could be either flexible or rigid.

For the purposes of the present invention, it is important that the difference between the size of the image sensor chip packaged in the device 50 and the overall size of the device 50 (corresponding to the dimension X in Figure 1) is as small as possible.

Figures 4 and 5 illustrate a more detailed example of a solid state imaging device 50 suitable for the purposes of the present invention. The device 50 comprises an image sensor chip 60 having an image sensor array (not shown) formed on its top surface, sandwiched between top and bottom glass sheets 62 and 64. The glass sheets 62 and 64 are secured to the chip 60 by means of an epoxy adhesive. The epoxy 66 securing the top sheet 62 is optically transparent to allow light to impinge upon the sensor array of the chip 60 through the glass sheet 62 and epoxy 66.

The chip 60 has a plurality of electrical contact pads 68 disposed around its periphery (Figure 5(a)). The package includes a corresponding plurality of electrically conductive leads or tracks 70 which are connected to the pads 68. The leads 70 each comprises a layer of conductive material formed on and extending down the sides of the package 50 and onto the bottom surface of the bottom glass sheet 64. The ends of the leads 70 are electrically connected to terminals 72 arranged in an array on the bottom surface of the glass sheet 64 (Figure 5(b)). The terminals 72 suitably comprise solder balls, an array of such terminals being known in the art as a ball grid array (BGA).

In this device 50, the pads 68 of the chip 60 are required to be larger than the pads needed for conventional wire-bonding techniques by which chips are normally connected in conventional packages. The pads 68 add about 100 m to the width/breadth of the chip, but this is significantly smaller than the additional space required for conventional wire-bonding (typically greater than 1 mm). It should also be noted that the thickness of the leads 70 as shown in Figure 4 has been greatly exaggerated. The actual thickness of the leads 70 would be less than 1 m. The difference between the size of the chip 60 and the complete device 50 is also exaggerated in Figure 4.

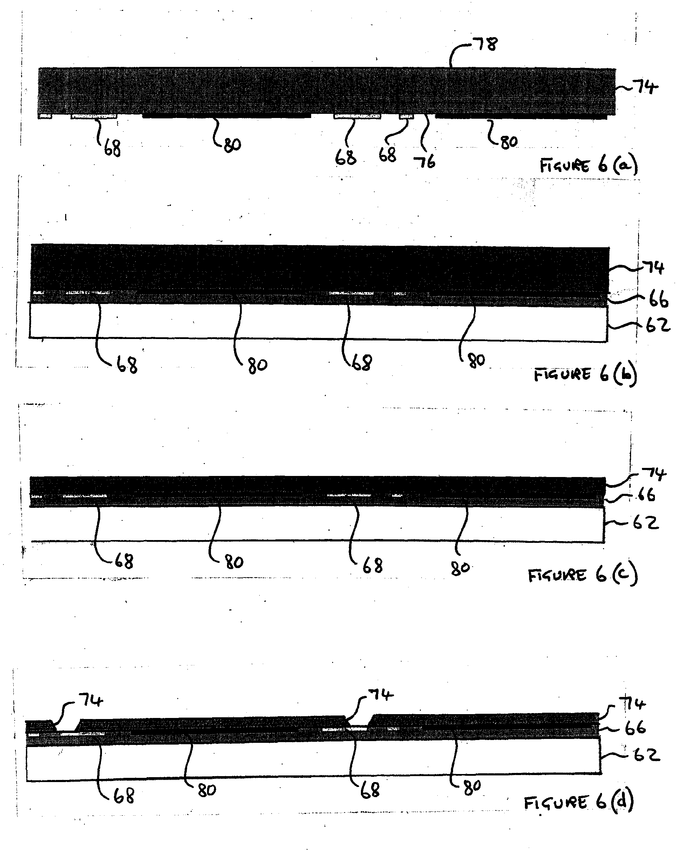

Figures 6(a)-(h) illustrate a method of manufacturing the device 50 of Fig. 4, using techniques known as "chip-scale packaging". Examples of such techniques are disclosed in US-A-5,455,455, US-A-5,547,906, and US-A-5,716,759. Chip-scale packaging is inexpensive and cost-effective, being based on processing whole wafers and thereby minimizing the expense of handling individual components during manufacture. Most of the process steps employ techniques and equipment already employed in semiconductor production for other purposes, thereby minimising capital expense and implementation costs. It has been found that the use of chip-scale packaging specifically for image sensor devices allows both the size and cost of the devices to be reduced, and enables electrical connections and terminals to be arranged in a manner which maximises the useful sensing area relative to the overall package size.

Figure 6(a) shows part of a wafer from which a plurality of packaged sensor chips 60 will be formed. The wafer comprises a substrate 74 having an obverse surface 76 and a reverse surface 78. The necessary chip circuitry 80 including the sensor array is formed on the obverse surface 76, together with the extended metallic contact pads 68. Where the sensor device is a colour imaging device, it is preferred that the necessary colour filter array be deposited on the sensor array as an integral part of the wafer-scale sensor fabrication process. The obverse surface 76 of the substrate 74 is then coated with optically transparent epoxy 66 and the top glass sheet 62 applied thereto, as shown in Figure 6(b).

Once the epoxy 66 has cured, the substrate 74 is thinned as shown in Figure 6(c) to approximately 40 m. The glass sheet 62 provides mechanical support for the substrate 74 during and after the thinning process. Thinning may be performed by mechanical grinding of the reverse surface 78 of the substrate 74, followed by chemical/reactive ion etching for the final few microns. These techniques combine speed (and hence low cost) and minimize stress and cracks in the substrate 74.

The reverse side 78 of the wafer is then patterned with a photoresist leaving the gaps between adjacent devices exposed, followed by selective etching to remove the substrate material between the devices and exposing the metal contact pads 68, as shown in Figure 6(d). The reverse side of the remaining assembly is then coated with epoxy 82 and the bottom glass sheet 64 applied thereto as shown in Figure 6(e). It is advantageous to use the same material (glass in this case) on both the obverse and reverse sides of the device, in order to minimise stresses caused by differential thermal expansion/contraction of the sheets 62 and 64.

Deep notches 84 are then formed between adjacent devices, e.g. by means of a diamond saw, extending through the bottom glass sheet 64 and the etched spaces between the devices to the surface of the top glass sheet 62, as seen in Figure 6(f), exposing the edges of the pads 68 around the periphery of each device. Metal (e.g. aluminium) is deposited (e.g. by vapour deposition techniques) onto the exterior surfaces of the bottom sheet 64 and the sides of the notches 84, contacting the exposed edges of the pads 68, and then etched to form the leads 70, as shown in Figure 6(g). Finally, the solder balls 72 are added in contact with the metal leads 70 and the top glass sheet 62 is cut using a diamond saw to separate the devices into individual packages as shown in Figure 6(h). The packaged devices can then be tested and assembled onto the flexible PCBs 52.

The flexible PCBs employed by the invention may be of generally known type, suitably formed from materials such as polyimide film with copper coating and having a total thickness of the order of 0.2 mm. PCBs of this type can typically be creased with a bend radius of about 0.4 mm. As noted above, mechanical stiffening elements may be employed as required or hybrid flex-rigid PCB structures may be used.

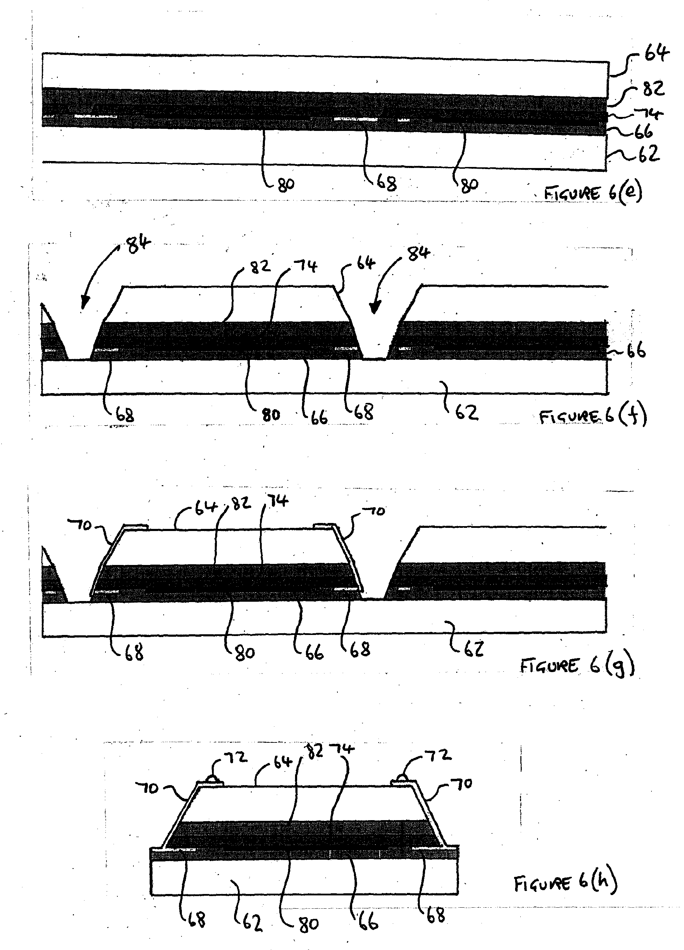

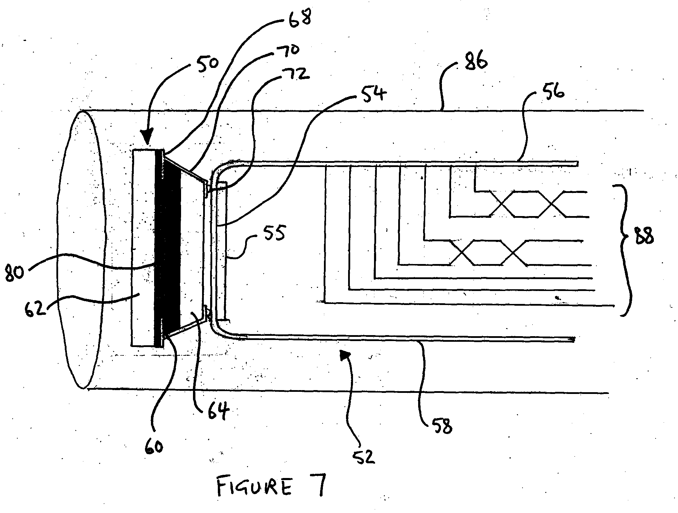

Figure 7 illustrates the distal end of an endoscope apparatus incorporating an image sensor device in accordance with the invention. The solid state imaging device 50 mounted on the flexible PCB 52 is located within a generally tubular casing 86 of the endoscope adjacent the distal end thereof. A suitable lens system (not shown) would be located in front of the imaging device 50. The sensor array 80 of the imaging device 50 is disposed transversely, substantially at right angles to the longitudinal axis of the casing 86, as in the arrangement illustrated in Figure 1(c). The tail portions 56 and 58 of the PCB 52 are bent rearwardly relative to the imaging device 50, so as to be enclosed within the volume of a notional parallelepiped projected rearwardly from the imaging device 50. The drawing shows cables 88 (comparable to the cables 18 of Figure 1(a)) connected to one of the tail portions 56 and extending rearwardly therefrom along the interior of the casing 86 towards the proximal end of the endoscope.

The invention enables the transversely mounted imaging device 50 to be made as large as possible in relation to the inner diameter of the casing (see Figure 1(c)), and enables the sensor chip 60 to be as large as possible in relation to the overall dimensions of the imaging device 50, thus allowing the sensor array 80 of the device to be as large as possible in relation to the cross-sectional area of the endoscope casing 86.

The fabrication of the packaged imaging device 50 and its mounting on the flexible PCB 52 are also relatively inexpensive, so that the invention provides a suitable basis for low-cost, disposable endoscope apparatus.

Improvements and modifications may be incorporated without departing from the scope of the invention as defined in the Claims appended hereto.

## Claims

1. An image sensor device comprising a solid state imaging device including an image sensor array and mounted on a printed circuit board, wherein said solid state imaging device includes a plurality of electrical terminals on a reverse surface thereof whereby the solid state imaging device is electrically connected to a first portion of said printed circuit board, and wherein said printed circuit board is at least partially flexible so as to enable at least a second portion thereof to be bent relative to said first portion.

2. An image sensor device as claimed in Claim 1, wherein said solid state imaging device comprises a packaged sensor chip, said sensor chip having a plurality of electrical contact pads disposed on the periphery thereof, and said contact pads being connected to said terminals by means of electrically conductive tracks formed on an exterior surface of the solid state imaging device and extending rearwardly from said contact pads around said exterior surface of the solid state imaging device.

3. An image sensor device as claimed in Claim 2, wherein edges of said sensor chip are exposed at the sides of said solid state imaging device.

4. An image sensor device as claimed in Claim 2 or Claim 3, wherein said sensor chip includes a transparent front cover member.

5. An image sensor device as claimed in any one of Claims 2 to 4, wherein said sensor chip is sandwiched between said transparent front cover member and a rear cover member, and edges of said sensor chip are exposed at the sides of said solid state imaging device between said front and rear cover members.

6. An image sensor device as claimed in Claim 5, wherein said front and rear cover members are both formed from glass.

7. An image sensor device as claimed in any preceding Claim, wherein said first portion of said printed circuit board has an area no larger than the area of the solid state imaging device plus 1 mm per side, and said at least one second portion of said printed circuit board comprises at least one tail portion extending from at least one edge of said first portion, said tail portion being capable of being bent rearwardly with respect to said solid state imaging device so as to be disposed within the volume of a notional parallelepiped projected rearwardly from said solid state imaging device.

8. An image sensor device as claimed in Claim 7, wherein said first portion of said printed circuit board has an area equal to or less than the area of the solid state imaging device.

9. An image sensor device as claimed in Claim 7 or Claim 8, wherein said tail portion is adapted to have at least one electrical cable connected thereto.

10. An image sensor device as claimed in any one of Claims 7 to 9, wherein said printed circuit board is a flexible printed circuit board.

11. An image sensor device as claimed in Claim 10, wherein said flexible printed circuit board includes mechanical stiffening means associated with said first portion thereof.

12. An image sensor device as claimed in any one of Claims 7 to 9, wherein said printed circuit board is a flex-rigid printed circuit board, including flexible elements at least in portions thereof connecting said first and second portions.

13. Endoscope apparatus comprising a generally tubular casing having an image sensor device as defined in any preceding Claim located in said casing adjacent a distal end of the apparatus with said sensor array disposed substantially at right angles to a longitudinal axis of said casing.
